# DEMANDE DE BREVET EUROPEEN

(11) **EP 4 842 195 A1**
(43) Date de publication de la demande: **18.11.2026**
(21) Numéro de dépôt: 26177085.3
(22) Date de dépôt: 07.05.2026
(51) Int. Cl.: H10W 72/30, H10D 10/80, H10P 90/00, H10W 40/10, H10W 40/22, H10W 72/00, H10W 90/00

(54) **PROCEDE D'ASSEMBLAGE DE DEUX DISPOSITIFS ELECTRONIQUES ET ASSEMBLAGE COMPRENANT DEUX DISPOSITIFS ELECTRONIQUES**

(30) Priorité: 12.05.2025 FR 2504999
(71) Demandeur: Centre National de la Recherche Scientifique, 75016 Paris (FR); STMicroelectronics International N.V., 1228 Plan-les-Ouates, Geneva (CH); Université de Lille, 59800 Lille (FR); Universite Polytechnique Hauts-de-France, 59313 Valenciennes Cedex 9 (FR)
(72) Inventeur: ZEMOUR, Abdelmalek, 59000 LILLE (FR); CHEVALIER, Pascal, 38530 CHAPAREILLAN (FR); ZEGAOUI, Malek, 59410 ANZIN (FR); ZAKNOUNE, Mohammed, 59000 LILLE (FR)
(74) Mandataire: Cabinet Beaumont

(57) **Abrégé**

La présente description concerne un procédé d'assemblage d'un premier dispositif (100) comprenant un substrat de type III-V avec un deuxième dispositif (150) comprenant un substrat comprenant du silicium (155), le procédé comprenant :
1) former une couche de métal (120) sur une première portion d'une face du premier dispositif (100) ;
2) former une première couche d'une résine sur la face du premier dispositif (100), la résine étant capable de se transformer en oxyde par l'application d'une étape de traitement ;
3) former une deuxième couche de la résine sur une face du deuxième dispositif (150) ; et
4) lier la face du premier dispositif (100) obtenu à l'étape 2) à la face du deuxième dispositif (150) obtenu à l'étape 3), en appliquant l'étape de traitement pour transformer la première couche de la résine et la deuxième couche de la résine en une couche d'oxyde (170).

## Description

### Domaine technique

La présente description concerne de façon générale les dispositifs électroniques et les procédés de fabrication de dispositifs électroniques et en particulier l'intégration de dispositifs comprenant un semiconducteur de type III-V sur des substrats comprenant du silicium.

### Technique antérieure

Les substrats de type III-V sont par exemple utilisés pour la fabrication de dispositifs électroniques aptes à l'utilisation de fréquences élevées.

Cependant, la fabrication de substrats composés d'un semiconducteur III-V ayant des dimensions relativement grandes, par exemple similaires aux dimensions atteignables pour des tranches de silicium, est difficile. De plus, des lignes de production à grande échelle adaptées à des substrats comprenant du silicium ne sont pas compatibles avec les tranches de type III-V.

Des procédés utilisant du benzocyclobutène (BCB) sont par exemple mis en œuvre pour assembler deux dispositifs mais ces procédés comprennent une ou plusieurs étapes effectuées à une température élevée, par exemple supérieure à 250°C. Des températures élevées génèrent du stress et des défauts cristallins dans les dispositifs ce qui impacte négativement des performances d'un dispositif électronique.

Il existe un besoin d'intégrer des structures développées sur un substrat de type III-V sur un substrat comprenant du silicium en utilisant des températures relativement basses.

### Résumé de l'invention

Un mode de réalisation prévoit un procédé d'assemblage d'un premier dispositif comprenant un substrat de type III-V avec un deuxième dispositif comprenant un substrat comprenant du silicium, le procédé comprenant :
1) former une couche de métal sur une première portion d'une face du premier dispositif ;
2) former une première couche d'une résine sur tout ou une partie de la face du premier dispositif après la formation de la couche de métal, la résine étant capable de se transformer en oxyde par l'application d'une étape de traitement ;
3) former une deuxième couche de la résine sur tout ou une partie d'une face du deuxième dispositif ; et
4) lier la face du premier dispositif obtenu à l'étape 2) à la face du deuxième dispositif obtenu à l'étape 3), en appliquant l'étape de traitement pour transformer la première couche de la résine et la deuxième couche de la résine en une couche d'oxyde.

Selon un mode de réalisation, le procédé comprend en outre, entre l'étape 1) et l'étape 2) :
- former une couche de protection sur une deuxième portion de la face du premier dispositif obtenu à l'étape 1).

Selon un mode de réalisation, la couche de protection recouvre la couche de métal et recouvre une partie d'une surface du substrat du premier dispositif, et, à la suite de l'étape 4), le deuxième dispositif n'est séparé de la couche de métal qu'uniquement par la couche d'oxyde et la couche de protection.

Selon un mode de réalisation, le procédé comprend en outre, après l'étape 2) et avant l'étape 4) :
- une étape de planarisation du premier dispositif pour rendre la couche de métal apparente.

Selon un mode de réalisation, le procédé comprend en outre, avant l'étape 3) :
- former une autre couche de métal sur une première portion de la face du deuxième dispositif,
et, à l'étape 4), la couche de métal et l'autre couche de métal sont liées entre elles.

Selon un mode de réalisation, le procédé comprend en outre, après la formation de l'autre couche de métal et avant l'étape 3) :
- former une autre couche de nitrure de silicium sur une deuxième portion de la face du deuxième dispositif.

Selon un mode de réalisation, l'étape de traitement est une étape de thermocompression.

Selon un mode de réalisation, l'étape de thermocompression est effectuée à une température inférieure ou égale à 250°C et de préférence inférieure ou égale à 200°C, et à une pression inférieure ou égale à 1200 mbar.

Selon un mode de réalisation, la résine comprend du silsesquioxane d'hydrogène.

Selon un mode de réalisation, avant l'étape 1), le substrat de type III-V du premier dispositif est composé d'un semiconducteur III-V et comprend un empilement d'une ou plusieurs couches dopées comprenant le semiconducteur III-V.

Un autre mode de réalisation prévoit un assemblage comprenant :
- un premier dispositif comprenant :
   1) une couche de métal ; et
   2) un substrat de type III-V recouvrant une première face de la couche de métal ; et
- un deuxième dispositif comprenant un substrat comprenant du silicium ;
une face du premier dispositif, opposée à la première face de la couche de métal, et une face du deuxième dispositif étant liées entre elles par une couche d'oxyde.

Selon un mode de réalisation, le deuxième dispositif comprend en outre une autre couche de métal recouvrant une portion du substrat comprenant du silicium et la couche de métal et l'autre couche de métal sont liées entre elles au niveau de la face du premier dispositif et de la face du deuxième dispositif.

Selon un mode de réalisation, le substrat de type III-V du premier dispositif est composé d'un semiconducteur III-V et comprend un empilement d'une ou plusieurs couches dopées comprenant le semiconducteur III-V, l'empilement de l'une ou plusieurs couches dopées formant un transistor bipolaire.

Selon un mode de réalisation, l'oxyde est du dioxyde de silicium.

Selon un mode de réalisation, le premier dispositif comprend en outre une couche de protection à l'interface entre la couche d'oxyde et la couche de métal.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C, la figure 1D, la figure 1E, la figure 1F, la figure 1G, la figure 1H et la figure 1I sont des vues en coupe d'étapes d'un procédé d'assemblage d'un premier dispositif comprenant un substrat de type III-V avec un deuxième dispositif comprenant un substrat comprenant du silicium, selon un mode de réalisation de la présente description ;
la figure 2 est une vue du dessus du dispositif de la figure 1I ;
la figure 3A, la figure 3B, la figure 3C et la figure 3D sont des vues en coupe d'étapes d'un procédé d'assemblage d'un premier dispositif comprenant un substrat de type III-V avec un deuxième dispositif comprenant un substrat comprenant du silicium, selon un autre mode de réalisation de la présente description ;
la figure 4 est une vue du dessus d'un assemblage, selon un mode de réalisation de la présente description ; et
la figure 5 illustre des performances de transistors formés sur différents substrats.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, des étapes de formation de couches dopées dans un substrat ou de déposition de couches sur un substrat et des étapes de façonnage (photolithographie, gravure, planarisation, etc.) de ces couches ne sont pas détaillées, la réalisation de telles étapes étant à la portée de la personne du métier à partir des indications de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

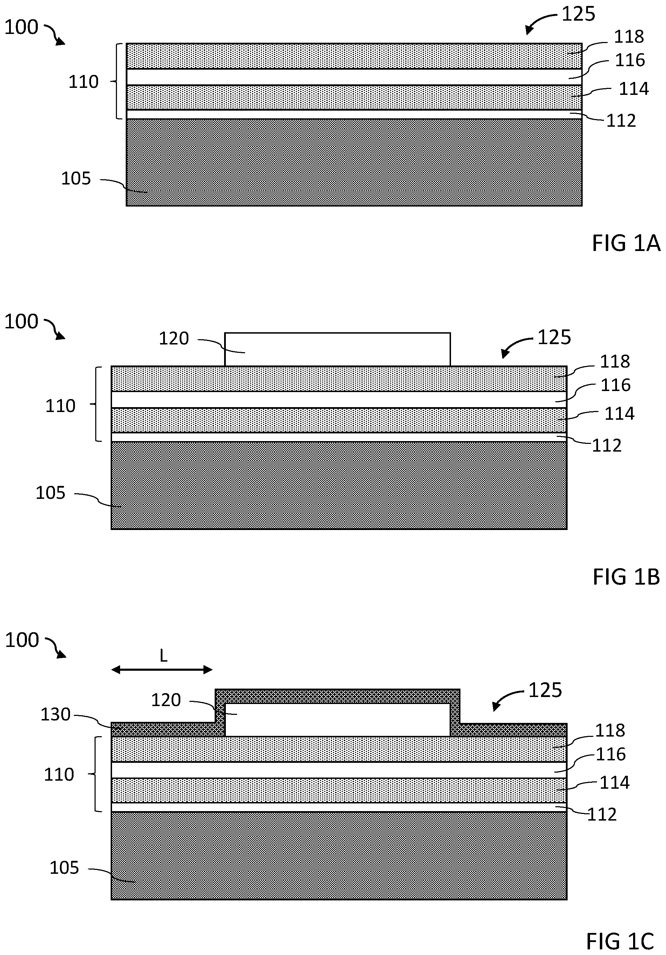

Les figures 1A à 1I sont des vues en coupe d'étapes d'un procédé d'assemblage d'un premier dispositif comprenant un substrat de type III-V avec un deuxième dispositif comprenant un substrat comprenant du silicium, selon un mode de réalisation de la présente description.

Le procédé décrit en relation avec les figures 1A à 1I est par exemple mis en œuvre pour une intégration de semiconducteurs III-V sur un substrat comprenant du silicium. Le procédé décrit en relation avec les figures 1A à 1I est par exemple mis en œuvre pour la formation de composants électroniques, par exemple des transistors, comprenant un semiconducteur III-V sur un substrat comprenant du silicium.

La figure 1A présente un exemple du premier dispositif 100. Le premier dispositif 100 comprend un substrat de type III-V 105. Par substrat de type III-V, on entend un substrat comprenant un semiconducteur III-V, c'est-à-dire un matériau comprenant un ou plusieurs éléments de la colonne III du tableau périodique de Mendeleïev (bore, aluminium, gallium, indium, etc.) et un ou plusieurs éléments de la colonne V du tableau périodique de Mendeleïev (azote, phosphore, arsenic, etc.). Par exemple, le substrat de type III-V 105 comprend du phosphore d'indium, du nitrure de gallium, etc. Le substrat 105 correspond par exemple à une partie d'une tranche, ou galette, constituée d'un semiconducteur III-V. Le substrat de type III-V 105 est par exemple obtenu par épitaxie.

Le substrat de type III-V 105 comprend par exemple un empilement de couches 110 à la surface du substrat 105. L'empilement de couches 110 comprend par exemple une ou plusieurs couches. Chacune des couches de l'empilement de couches 110 est par exemple déposée sur une face du substrat 105 et/ou est par exemple obtenue en dopant le substrat 105 pour former une couche du semiconducteur III-V avec un niveau de dopage fixé. Selon un mode de réalisation, le substrat 105 comprend au moins une couche active, c'est-à-dire dopée, du semiconducteur III-V.

Dans l'exemple de la figure 1A, l'empilement de couches 110 est constitué d'un empilement de quatre couches superposées 112, 114, 116 et 118 de sorte que la couche 118 soit exposée sur une face 125 du substrat 105 et du premier dispositif 100. Par exemple, la face 125 est la face de dessus du dispositif 100.

La figure 1B présente le premier dispositif 100 de la figure 1A après une étape de formation d'une couche de métal 120 sur la face 125 du premier dispositif 100. En particulier, la couche de métal 120 recouvre au moins partiellement la couche 118 de l'empilement de couches 110.

La couche de métal 120 est par exemple constituée d'aluminium, de cuivre, de tungstène, de titane, etc. ou d'un alliage de plusieurs de ces métaux.

La couche de métal 120 est par exemple formée par une étape de dépôt suivie d'une étape de photolithographie et de gravure ou par un procédé de décollage (en anglais, « lift-off ») .

La couche de métal 120 a par exemple une épaisseur comprise dans la plage allant de 0,5 µm à 1,5 µm.

La figure 1C présente le premier dispositif 100 de la figure 1B après une étape de formation d'une couche de protection 130, par exemple une couche diélectrique, par exemple composée de nitrure de silicium ou d'oxyde de silicium.

La couche 130 est par exemple formée sur la face 125 du premier dispositif 100. En particulier, la couche 130 recouvre par exemple entièrement la couche de métal 120 et recouvre par exemple en outre partiellement le substrat 105. En particulier, la couche 130 est par exemple en contact direct avec une face du substrat 105 correspondant à la face 125 et recouvre par exemple une portion du substrat 105 dans toutes les directions en partant de la couche de métal 120, par exemple sur une distance L supérieure ou égale à 1 µm, par exemple supérieure ou égale à 10 µm. Par exemple, la couche de protection 130 est déposée sur l'ensemble de la face 125 du premier dispositif 100.

La couche 130 est par exemple formée par un dépôt chimique en phase vapeur assisté par plasma (PECVD, de l'anglais « plasma-enhanced chemical vapor deposition »).

La couche 130 a par exemple une épaisseur comprise dans la plage allant de 10 nm à 100 nm, par exemple comprise dans la plage allant de 20 nm à 50 nm.

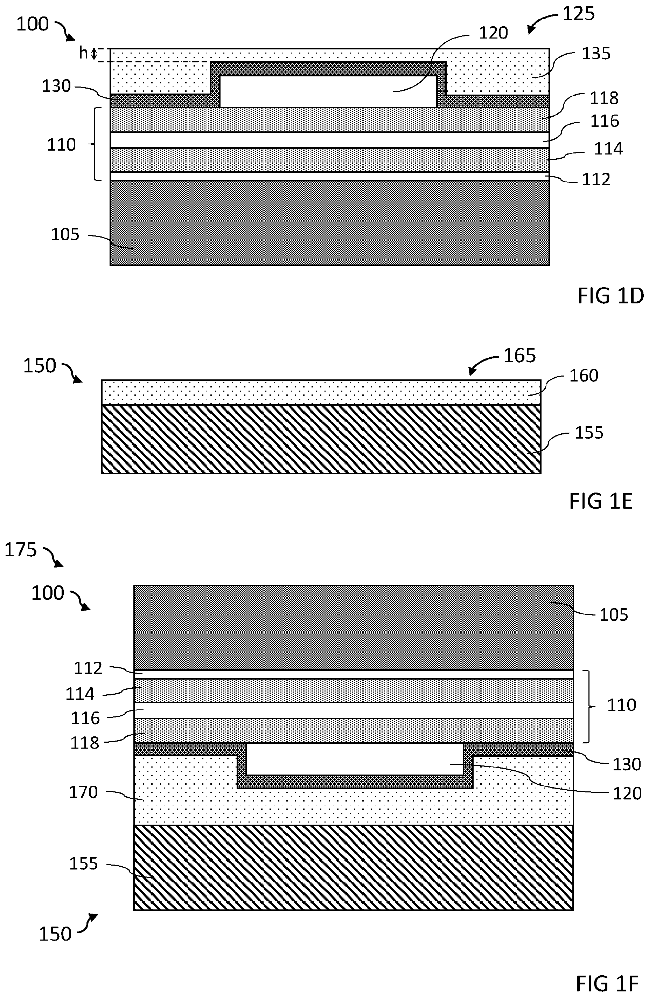

La figure 1D présente le premier dispositif 100 de la figure 1C après une étape de formation d'une première couche d'une résine 135 sur tout ou une partie de la face 125 du premier dispositif 100. La couche 135 recouvre au moins partiellement la couche de protection 130.

Selon un autre mode de réalisation, l'étape illustrée à la figure 1C est omise et la première couche 135 recouvre par exemple directement la couche de métal 120 et recouvre par exemple partiellement le substrat 105.

La résine est configurée pour se transformer en un oxyde en appliquant une étape de traitement. Par exemple, la résine comprend du silsesquioxane d'hydrogène (HSQ) et se transforme en dioxyde de silicium lors d'une étape de bombardement d'électrons ou dans des conditions de température et de pression adéquates. Avantageusement, le silsesquioxane d'hydrogène a une constante diélectrique relativement faible et est compatible avec des procédés de fabrication connus et relativement peu contraignants.

La couche 135 est par exemple déposée par enduction centrifuge (en anglais, « spin coating »).

La couche 135 a par exemple une épaisseur minimale h, par exemple à l'aplomb de la couche de métal 120, comprise dans la plage allant de 50 nm à 250 nm, par exemple comprise dans la plage allant de 100 nm à 200 nm.

Selon un mode de réalisation, l'étape de formation de la première couche 135 est configurée pour que la couche de métal 120 soit au moins partiellement enterrée dans la couche 135. Autrement dit, la couche 135 recouvre, au moins partiellement, plusieurs faces de la couche de métal 120, directement ou par l'intermédiaire de la couche de protection 130.

La couche 130, localisée à l'interface entre la couche de métal 120 et la couche 135, est par exemple configurée pour protéger la couche de métal 120 de la résine et/ou de composants chimiques utilisés lors du procédé de dépôt de la résine. En particulier, le nitrure de silicium protège, par exemple, une couche en aluminium du silsesquioxane d'hydrogène.

La couche 130, localisée à l'interface entre le substrat 105 et la couche 135, est par exemple configurée pour promouvoir ou améliorer l'adhérence de la résine sur le substrat 105. En particulier, le nitrure de silicium améliore l'adhérence du silsesquioxane d'hydrogène sur un substrat en phosphore d'indium.

La figure 1E présente un exemple du deuxième dispositif 150 après une étape de formation d'une deuxième couche de la résine 160 sur tout ou une partie d'une face 165 du deuxième dispositif 150. La face 165 est par exemple la face de dessus du dispositif 150.

Le deuxième dispositif 150 comprend un substrat comprenant du silicium 155. Le substrat 155 correspond par exemple à une partie d'une tranche, ou galette, de silicium, par exemple une tranche de silicium à haute résistance électrique. Une tranche de silicium à haute résistance électrique est par exemple adaptée à une utilisation d'ondes ayant une fréquence radio et permet par exemple un meilleur facteur de qualité de composants électroniques.

Le substrat 155 est par exemple un substrat compatible avec la formation de composants CMOS (de l'anglais « complementary metal oxide semiconductor ») ou BiCMOS (de l'anglais « bipolar - complementary metal oxide semiconductor »).

Selon un mode de réalisation, non illustré en figure 1E, une couche de protection, par exemple une couche diélectrique, par exemple composée de nitrure de silicium est déposée sur la face 165 du substrat 155, avant la formation de la couche 160, selon un procédé détaillé en relation avec la figure 1C.

La couche 160 est par exemple déposée par enduction centrifuge.

La couche 160 a par exemple une épaisseur comprise dans la plage allant de 50 nm à 300 nm, par exemple comprise dans la plage allant de 100 nm à 200 nm.

La figure 1F représente le premier dispositif 100 de la figure 1D et le deuxième dispositif 150 de la figure 1E après une étape d'assemblage de la face 125 du premier dispositif 100 à la face 165 du deuxième dispositif 150.

Une étape de traitement est par exemple appliquée pour transformer la couche 135 et la couche 160 de la résine en une couche d'oxyde 170. Au cours de l'étape de traitement, la couche 135 et la couche 160 fusionnent par exemple en la couche d'oxyde 170. La résine se transforme par exemple en oxyde. Un collage moléculaire se forme par exemple à l'interface entre la couche 135 et la couche 160.

La couche d'oxyde 170 comprend par exemple du dioxyde de silicium (SiO₂) et/ou de l'oxyde de silicium (SiOₓ). Selon un mode de réalisation, la résine comprend du silsesquioxane d'hydrogène et, au cours de l'étape de traitement, la transformation du silsesquioxane d'hydrogène en dioxyde de silicium n'est pas complète.

Un avantage de l'utilisation d'une résine pour les étapes détaillées en relation avec les figures 1D et 1E est l'obtention de couches ayant une relativement faible rugosité de surface. En particulier, le silsesquioxane d'hydrogène permet l'obtention de couches ayant une relativement faible rugosité de surface, par exemple comprise dans la plage allant de 2 nm à 5 nm. L'obtention de couches ayant une relativement faible rugosité de surface favorise une intégration à grande échelle des procédés de fabrication et favorise un meilleur contact entre la couche 135 et la couche 160 ce qui favorise l'assemblage entre la couche 135 et la couche 160. En outre, l'obtention de couches ayant une relativement faible rugosité de surface permet par exemple l'obtention d'une couche ayant une épaisseur relativement uniforme et par exemple de réduire l'épaisseur moyenne de la couche requise.

Un autre avantage de l'utilisation d'une résine est une compensation de défauts de surfaces de la couche sur laquelle la résine est déposée.

Selon un mode de réalisation, l'étape de traitement est une étape de thermocompression. Par exemple, le premier dispositif 100 et le deuxième dispositif 150 sont positionnés en contact de sorte que la face 125 du premier dispositif 100 soit en contact avec la face 165 du deuxième dispositif 150 et une température et une pression adéquates sont appliquées sur un assemblage électronique 175 formé par le premier dispositif 100 et par le deuxième dispositif 150. Par exemple, une température inférieure ou égale à 250°C, par exemple inférieure ou égale à 200°C et une pression inférieure ou égale à 1600 mbar, par exemple inférieure ou égale à 1200 mbar sont appliquées à l'assemblage 175.

Selon un mode de réalisation, l'étape de thermocompression comprend un recuit qui est appliqué séparément au premier dispositif 100 et au deuxième dispositif 150. Le recuit a par exemple une durée environ égale à 5 minutes. Le recuit est par exemple effectué à une température comprise dans la plage allant de 150°C à 200°C. L'étape de thermocompression comprend par exemple en outre, après le recuit, une étape de collage au cours de laquelle la couche 135 et la couche 160 fusionnent en la couche d'oxyde 170. La résine se transforme par exemple en oxyde. L'étape de collage a par exemple une durée environ égale à 1,5 heures. L'étape de collage est par exemple effectuée à une température comprise dans la plage allant de 150°C à 200°C. L'étape de collage est par exemple effectuée à une pression comprise dans la plage allant de 600°mbar à 1000 °mbar. L'étape de thermocompression comprend par exemple en outre, après l'étape de collage, une étape de densification et de stabilisation de la couche d'oxyde 170. Une température approximativement égale à 120°C est par exemple appliquée à l'assemblage 175 pendant environ 5 minutes puis une température approximativement égale à 150°C est par exemple appliquée à l'assemblage 175 pendant environ 5 minutes puis une température approximativement égale à 180°C est par exemple appliquée à l'assemblage 175 pendant environ 5 minutes puis une température approximativement égale à 200°C est par exemple appliquée à l'assemblage 175 pendant environ 30 minutes.

L'étape d'assemblage est par exemple compatible avec des procédés de fabrication CMOS.

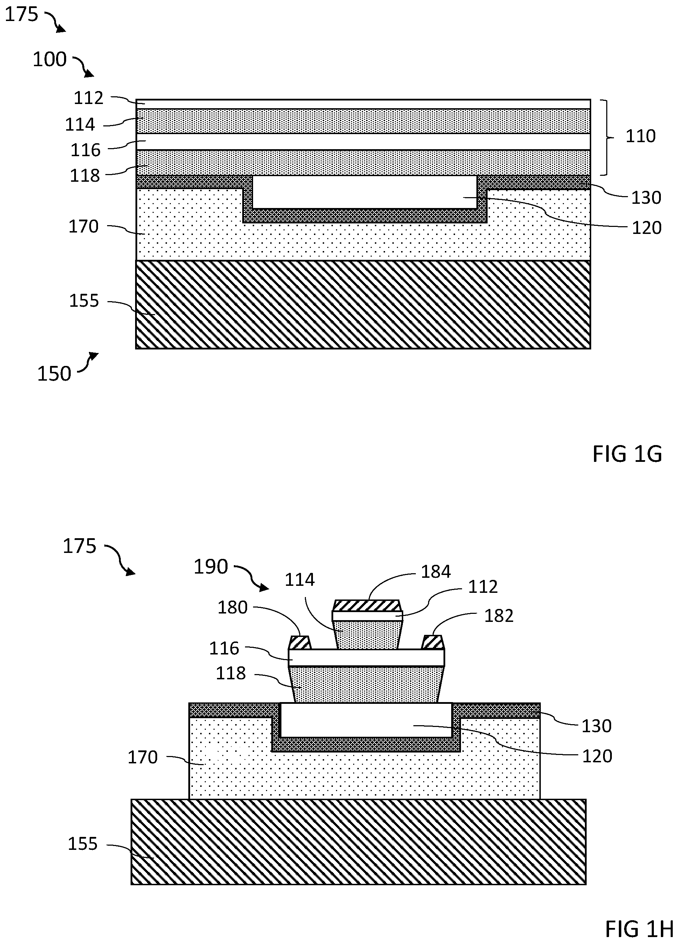

La figure 1G représente l'assemblage 175 de la figure 1F après une étape de retrait d'une partie du substrat 105.

Une partie du substrat 105 est par exemple retirée par une étape d'amincissement mécanique, par, exemple suivie d'une étape d'amincissement chimique configurée pour exposer l'empilement de couches 110. La couche d'oxyde 170 protège par exemple la couche de métal 120 lors de l'étape de retrait.

Le procédé détaillé en relation avec les figures 1A à 1G permet l'obtention d'un assemblage comprenant des couches actives du semiconducteur III-V sur un substrat comprenant du silicium.

L'assemblage 175, illustré en figure 1G, comprend le premier dispositif 100 et le deuxième dispositif 150. Le premier dispositif 100 comprend la couche de métal 120 et le substrat de type III-V 105, le substrat de type III-V 105 recouvrant une face de la couche de métal 120. Le deuxième dispositif 150 comprend le substrat comprenant du silicium 155. La face 125 du premier dispositif 100, opposée à la face de la couche de métal 120, et la face 165 du deuxième dispositif 150 sont liées entre elles par la couche d'oxyde 170.

Selon un mode de réalisation, la couche de métal 120 est au moins partiellement enterrée dans la couche d'oxyde 170. Autrement dit, la couche d'oxyde 170 recouvre, au moins partiellement, plusieurs faces de la couche de métal 120, directement ou par l'intermédiaire de la couche de protection 130.

Selon un mode de réalisation, le substrat 155 n'est séparé de la couche de métal 120 qu'uniquement par la couche d'oxyde 170.

Selon un autre mode de réalisation, le substrat 155 n'est séparé de la couche de métal 120 qu'uniquement par la couche d'oxyde 170 et la couche de protection 130.

La figure 1H représente l'assemblage 175 de la figure 1G après une ou plusieurs étapes de façonnage de l'empilement de couches 110. Les étapes de façonnage, non détaillées, sont configurées pour former un composant électronique, par exemple une diode, un transistor, etc.

Dans l'exemple de la figure 1H, le composant électronique est un transistor bipolaire 190, par exemple un transistor bipolaire à double hétérojonction (DHBT, de l'anglais « double heterojunction bipolar transistor »). Dans l'exemple des figues 1A à 1I, la couche 118 est par exemple configurée pour former un collecteur du transistor, la couche 116 est par exemple configurée pour former une base du transistor, la couche 114 est par exemple configurée pour former un émetteur du transistor et la couche 112 est par exemple configurée pour former une couche superficielle de l'émetteur du transistor.

Selon un mode de réalisation, le composant électronique est en contact direct avec la couche 120 sur une surface de contact et la couche 120 a par exemple une surface supérieure à la surface de contact. Dans l'exemple de la figure 1H, le collecteur du transistor bipolaire 190 est en contact avec la couche 120. Par exemple, la couche 120 s'étend dans toutes les directions en partant du composant électronique, par exemple sur une distance comprise entre 5 µm et 25 µm. Avantageusement, lorsque la couche 120 a des dimensions plus larges que la surface de contact, la couche 120 sert de point de contact électrique pour relier le composant électrique au substrat 155 ou à d'autres composants électroniques, non illustrés dans la figure 1H.

Un plot de connexion 180 et un plot de connexion 182 sont par exemple chacun formé en contact avec la couche 116 et un plot de connexion 184 est par exemple formé en contact avec la couche 112. Les plots de connexion 180, 182 et 184 sont par exemple configurés pour être reliés à d'autres composants électroniques, non illustrés.

Dans l'exemple de la figure 1H, la couche 130 et la couche 170 ont également été façonnées. Par exemple, une ou plusieurs étapes de gravure sont effectuées pour obtenir l'assemblage 175 de la figure 1H à partir de l'assemblage 175 de la figure 1G. En particulier, la couche 130 et la couche 170 ont par exemple été gravées, à l'écart de la couche 120, par exemple jusqu'à exposer le substrat 155. Cette étape est par exemple configurée pour séparer l'assemblage 175 d'autres éléments, non illustrés à la figure 1H, couplés au substrat 155.

L'assemblage 175 obtenu par le procédé détaillé en relation avec les figures 1A à 1G comprend un transistor bipolaire 190 formé dans des couches actives de semiconducteur III-V et couplé au substrat 155 comprenant du silicium.

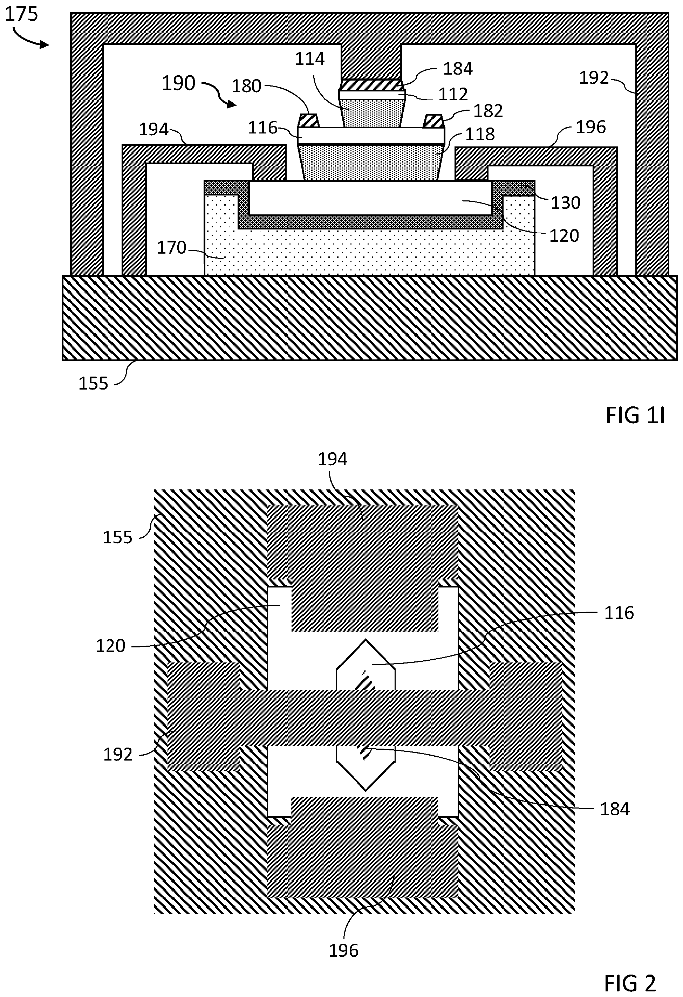

La figure 1I représente l'assemblage 175 de la figure 1H après une ou plusieurs étapes de connexion du transistor bipolaire 190 au substrat 155.

Le plot de connexion 184 est par exemple connecté au substrat 155 par l'intermédiaire d'un élément de connexion 192 conducteur, de préférence métallique, par exemple en cuivre.

La couche de métal 120 est par exemple connectée au substrat 155 par l'intermédiaire d'un ou plusieurs éléments de connexion 194, 196 conducteurs, de préférence métalliques, par exemple en cuivre.

Les éléments de connexion 192, 194, 196 sont par exemple configurés pour relier électriquement le transistor bipolaire 190 au substrat 155.

Les éléments de connexion 192, 194, 196 sont par exemple configurés pour dissiper une énergie thermique, par exemple générée par le transistor bipolaire 190, vers le substrat 155.

La couche de métal 120 est par exemple configurée pour relier électriquement et/ou thermiquement l'empilement de couches 110 détaillé en relation avec les figures 1A à 1G au substrat 155, par exemple par l'intermédiaire des éléments de connexion 194, 196. En particulier, la couche de métal 120 est par exemple configurée pour relier électriquement le collecteur 118 du transistor bipolaire 190 au substrat 155 et la couche de métal 120 est par exemple configurée pour dissiper de l'énergie thermique générée par le transistor bipolaire 190 vers le substrat 155. L'utilisation d'un métal pour la couche 120 permet une relativement bonne conduction électrique et thermique entre le transistor bipolaire 190 et le substrat 155.

Selon des modes de réalisation où l'étape illustrée à la figure 1C est omise, la couche de métal 120 est par exemple configurée pour directement relier électriquement et/ou thermiquement l'empilement de couches 110 détaillé en relation avec les figures 1A à 1G au substrat 155.

La figure 2 est une vue du dessus du dispositif de la figure 1I.

Certains éléments de la figure 2 sont identiques à des éléments de la figure 1I, et ces éléments sont désignés par les mêmes références et ne sont pas décrits à nouveau en détail.

Bien que dans l'exemple des figures 1I et 2, la couche 120 soit reliée au substrat 155 par l'intermédiaire de deux éléments de connexion 194, 196, dans d'autres modes de réalisation, la couche 120 est reliée au substrat 155 par l'intermédiaire d'un ou plusieurs éléments de connexion étant en contact avec tout ou une partie du périmètre de la couche 120.

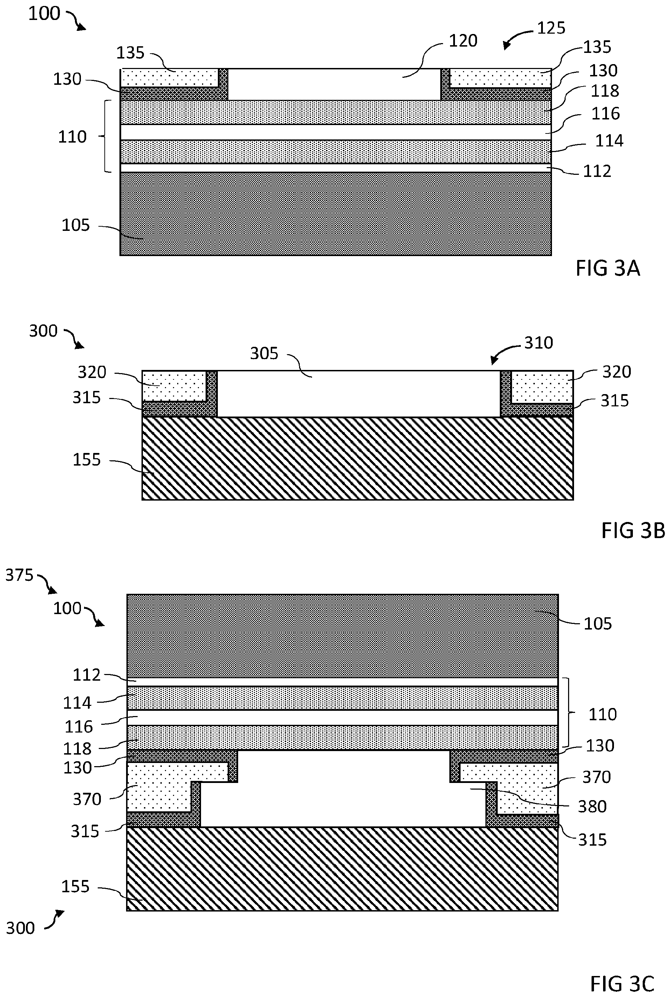

Les figures 3A à 3D sont des vues en coupe d'étapes d'un procédé d'assemblage d'un premier dispositif comprenant le substrat de type III-V 105 avec un deuxième dispositif comprenant le substrat comprenant du silicium 155, selon un autre mode de réalisation de la présente description.

Les étapes des figures 1A à 1D sont par exemple effectuées selon le procédé détaillé en relation avec ces figures.

La figure 3A correspond au premier dispositif 100 de la figure 1D obtenu après une étape de planarisation du premier dispositif 100 configurée pour exposer la couche de métal 120.

La couche de résine 135 et/ou la couche de protection 130 sont par exemple partiellement retirées, par exemple par une étape de polissage mécano-chimique, autrement dit planarisation mécano-chimique (CMP, de l'anglais « chemical mechanical polishing »). Une face de la couche 120 est ainsi exposée sur la face 125 du premier dispositif 100.

Bien que la couche 130 soit illustrée dans la figure 3A, elle pourrait être omise dans d'autres modes de réalisation.

La figure 3B illustre un exemple du deuxième dispositif 300 selon un mode de réalisation.

Le deuxième dispositif 300 comprend par exemple le substrat 155 comprenant du silicium.

Le deuxième dispositif 300 comprend par exemple en outre une autre couche de métal 305. L'autre couche de métal 305 est par exemple formée sur une face 310 du deuxième dispositif 300. La face 310 du dispositif 300 est par exemple la face de dessus.

L'autre couche de métal 305 est par exemple constituée d'aluminium, de cuivre, de tungstène, de titane, etc. ou d'un alliage de plusieurs de ces métaux. L'autre couche de métal 305 a par exemple la même composition que la couche de métal 120 du premier dispositif 100, non illustré en figure 3B.

L'autre couche de métal 305 est par exemple formée par une étape de dépôt suivie d'une étape de photolithographie et de gravure ou par un procédé de décollage (en anglais, « lift-off »).

L'autre couche de métal 305 a par exemple une épaisseur comprise dans la plage allant de 0,5 µm à 1,5 µm.

Le deuxième dispositif 300 comprend par exemple en outre une couche de protection 315, par exemple une couche diélectrique, par exemple composée de nitrure de silicium. La couche de protection 315 est par exemple formée selon l'étape de procédé détaillée en relation avec la figure 1C.

Le deuxième dispositif 300 comprend par exemple en outre une couche 320 de la résine détaillée en relation avec les figures 1A à 1I. La couche de la résine 320 est par exemple formée selon l'étape de procédé détaillée en relation avec la figure 1D. Une étape de planarisation du deuxième dispositif 300 est par exemple effectuée, par exemple telle que détaillée en relation avec la figure 3A, de sorte qu'une face de l'autre couche de métal 305 soit exposée sur la face 310 du deuxième dispositif 300.

Selon un autre mode de réalisation, non illustré dans la figure 3B, le deuxième dispositif 300 ne comprend pas de couche de protection. La couche de la résine 320 est par exemple déposée directement en contact avec le substrat 155 et avec l'autre couche de métal 305. L'étape de planarisation du deuxième dispositif 300 est alors configurée pour retirer partiellement la couche de la résine 320 et pour exposer l'autre couche de métal 305 sur la face 310 du deuxième dispositif 300.

La figure 3C représente le premier dispositif 100 de la figure 3A et le deuxième dispositif 300 de la figure 3B après une étape d'assemblage de la face 125 du premier dispositif 100 avec la face 310 du deuxième dispositif 300.

Le premier dispositif 100 et le deuxième dispositif 300 sont par exemple positionnés en contact de sorte que la face 125 du premier dispositif 100 soit en contact avec la face 310 du deuxième dispositif 300 et de sorte que la couche 135 et la couche 320 de la résine soient en contact et de sorte que la couche de métal 120 et l'autre couche de métal 305 soient en contact.

Une étape de traitement est par exemple appliquée pour transformer la couche 135 et la couche 320 de la résine en une couche 370 d'oxyde.

Selon un mode de réalisation, l'étape de traitement est une étape de thermocompression telle que détaillée par exemple en relation avec la figure 1F.

Selon un mode de réalisation, la couche de métal 120 et l'autre couche de métal 305 se lient mécaniquement lors de l'étape de traitement pour former une couche de métal 380. Par exemple, les paramètres de température et/ou de pression de l'étape de thermocompression sont configurés pour que la couche de métal 120 et l'autre couche de métal 305 se lient mécaniquement. Par exemple, deux couches d'aluminium en contact peuvent être liées mécaniquement en utilisant une pression inférieure ou égale à 1200 mbar et une température comprise dans la plage allant de 150°C à 250°C.

Un assemblage électronique 375 est ainsi formé, l'assemblage 375 comprenant le premier dispositif 100 et le deuxième dispositif 300 liés entre eux.

Le premier dispositif 100 de l'assemblage 375 comprend la couche de métal 120 et le substrat de type III-V 105, le substrat de type III-V 105 recouvrant une face de la couche de métal 120. Le deuxième dispositif 300 de l'assemblage 375 comprend le substrat comprenant du silicium 155 et l'autre couche de métal 305, l'autre couche de métal 305 recouvrant une portion de la face 310 du substrat comprenant du silicium 155. La face 125 du premier dispositif 100, opposée à la face de la couche de métal 120, et la face 310 du deuxième dispositif 300 sont liées entre elles par l'intermédiaire de la couche d'oxyde 170. La couche de métal 120 et l'autre couche de métal 305 sont en outre liées entre elles au niveau de la face 125 du premier dispositif 100 et de la face 310 du deuxième dispositif 300.

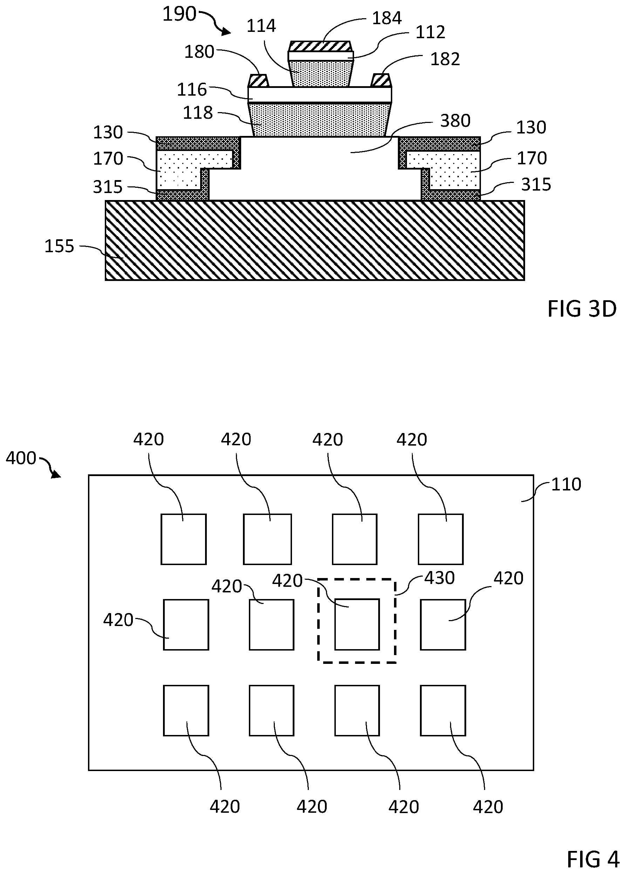

La figure 3D représente l'assemblage 375 de la figure 3C après une étape de retrait du substrat 105 et après une ou plusieurs étapes de façonnage de l'empilement de couches 110.

Ces étapes sont par exemple similaires aux étapes détaillées en relation avec les figures 1G et 1H.

Une différence entre l'assemblage illustré à la figure 1H et l'assemblage illustré à la figure 3D est que, dans l'assemblage illustré à la figure 3D, l'empilement de couches 110 est directement reliée au substrat 155 par l'intermédiaire de la couche de métal 380. L'assemblage illustré à la figure 3D a par exemple une meilleure dissipation thermique que l'assemblage illustré à la figure 1H ou à la figure 1I. La couche de métal 380 a par exemple en outre une meilleure conduction électrique que la couche de métal 120 couplée aux éléments de connexion 194, 196 illustrés à la figures 1I.

Un avantage d'une meilleure dissipation thermique dans un composant électronique est une augmentation de la puissance de sortie du composant électronique, par exemple pour un transistor.

Selon un mode de réalisation illustré dans les figures 3A à 3D, la couche de métal 305 a une surface plus importante que la surface de la couche de métal 120. En particulier, la couche de métal 305 est plus large que la couche de métal 120. En conséquence, l'alignement du premier dispositif 100 sur le deuxième dispositif 300 est facilité. Une précision de l'alignement est par exemple de l'ordre de 10¹ µm.

Selon un autre mode de réalisation, non illustré dans les figures 3A à 3D, la couche de métal 305 a une surface approximativement égale à la surface de la couche de métal 120.

La figure 4 est une vue du dessus d'un assemblage 400, selon un mode de réalisation de la présente description.

Bien que les procédés de fabrication aient été détaillés pour la fabrication d'un assemblage électronique, une multitude d'assemblages électroniques sont par exemple formés simultanément.

Selon un mode de réalisation, l'empilement de couches 110 détaillé en relation avec la figure 1A est formé sur l'ensemble d'une surface d'une face d'une tranche de type III-V, ou sur une surface relativement grande de la face de la tranche de type III-V.

L'assemblage 400 comprend, par exemple, une multitude de couches de métal 420, chacune semblable à la couche de métal 120. Les couches de métal 420 sont par exemple formées simultanément sur l'empilement de couches 110, par exemple au cours d'une étape de dépôt suivie d'une étape de photolithographie et de gravure ou par un procédé de décollage.

Bien que dans l'exemple illustré à la figure 4, chaque couche de métal 420 ait une forme rectangulaire, dans d'autres modes de réalisation chaque couche de métal 420 a par exemple une autre forme, par exemple hexagonal, circulaire, etc.

Une partie 430 de l'assemblage 400 est encadrée sur la figure 4 et correspond par exemple à une vue du dessus du premier dispositif 100 de la figure 1B.

Similairement, bien que cela ne soit pas illustré dans la figure 4, les étapes illustrées aux figures 1C à 1I sont par exemple réalisées simultanément pour une multitude de premiers dispositifs et pour une multitude de deuxièmes dispositifs. En particulier, lors de l'étape d'assemblage illustrée à la figure 1C, la couche de protection 130 est par exemple déposée sur l'ensemble de la tranche de type III-V. En particulier, lors de l'étape d'assemblage illustrée à la figure 1F, plusieurs tranches de types III-V sont par exemple liées simultanément sur une tranche comprenant du silicium.

Bien que dans l'exemple de la figure 4 l'assemblage 400 comprennent 12 premiers dispositifs 100, dans d'autres exemples, l'assemblage 400 comprend un nombre quelconque de premiers dispositifs 100, par exemple défini en fonction des dimensions du substrat 105, et par exemple égal à au moins deux.

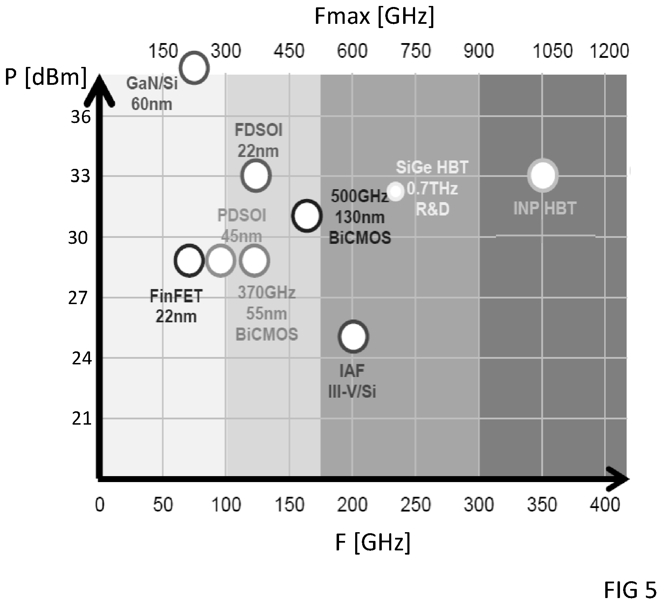

La figure 5 est un graphe représentant une fréquence porteuse (« F [GHz] ») et une fréquence maximale (« Fmax [GHz] »), en abscisses, et une puissance (« P [dBm] ») pour des exemples de technologies de transistors.

Par exemple, un transistor à effet de champ à ailettes (FinFET, de l'anglais « fin field-effect transistor ») ayant une grille mesurant 22 nm est par exemple mis en œuvre avec une fréquence porteuse de l'ordre de 65 GHz, une fréquence maximale de l'ordre de 200 GHz et une puissance approximativement égale à 29 dBm.

Par exemple, un transistor de type BiCMOS ayant une grille mesurant 130 nm est mis en œuvre avec une fréquence porteuse de l'ordre de 160 GHz, une fréquence maximale de l'ordre de 500 GHz et une puissance approximativement égale à 31 dBm.

Par exemple, un transistor bipolaire à hétérojonction (HBT, de l'anglais « heterojunction bipolar transistor ») formé sur un substrat de phosphore d'indium est par exemple mis en œuvre avec une fréquence porteuse de l'ordre de 350 GHz, une fréquence maximale de l'ordre de 1050 GHz et une puissance approximativement égale à 33 dBm. Un substrat de phosphore d'indium est par exemple adapté et performant pour la fabrication de composants électroniques, tels que les transistors, configurés pour fonctions avec des fréquences relativement élevées.

Par exemple, un transistor formé dans des couches de nitrure de gallium et couplé à un substrat de silicium est par exemple mis en œuvre avec une fréquence porteuse de l'ordre de 75 GHz, une fréquence maximale de l'ordre de 225 GHz et une puissance approximativement égale à 39 dBm. Le nitrure de gallium est par exemple adapté pour la fabrication de composants électroniques, tels que les transistors, configurés pour fonctions avec des puissances relativement élevées.

Les procédés de fabrication détaillés dans la présente description permettent la fabrication de composants électroniques comprenant une ou plusieurs couches d'un semiconducteur III-V sur un substrat comprenant du silicium. Un premier avantage est l'obtention de composants électroniques ayant des performances et/ou des caractéristiques techniques liées aux caractéristiques du semiconducteur III-V. Par exemple, le phosphore d'indium est compatible avec une utilisation d'un composant électronique à hautes fréquences, par exemple à des fréquences radio ou compatibles avec une norme 5G, 5G+, 6G, etc. Le phosphore d'indium est par exemple également utilisé pour des fréquences relativement moins élevées et avec des performances plus élevées, par exemple une puissance relativement élevée.

Avantageusement, la couche de métal 120 forme un point de contact électrique pour le composant électronique, par exemple pour le collecteur du transistor bipolaire 190.

Avantageusement, la couche de métal 120 participe à la dissipation d'une énergie thermique générée par l'empilement de couches 110 ou par un composant électronique formé dans l'empilement de couches 110, à l'interface entre l'empilement de couche 110 et le substrat 155. Une meilleure dissipation de l'énergie thermique améliore par exemple des performances de fonctionnement du composant électronique, par exemple des performances fréquentielles et en puissance, particulièrement pour des composants ayant des substrats de type III-V. Par exemple, une énergie thermique générée par un transistor bipolaire se dissipe principalement par son collecteur.

Avantageusement, dans certains modes de réalisation, la couche de métal 120 est en outre utilisée pour connecter électriquement l'empilement de couches 110 ou un composant électronique formé dans l'empilement de couches 110 au substrat 155 comprenant du silicium et/ou à d'autres composants électroniques.

Un avantage des procédés de fabrication détaillés dans la description est que la formation de la couche de métal 120 puisse être intégrée entre l'empilement de couches 110 et le substrat 155 comprenant du silicium.

Un avantage des assemblages obtenus par les procédés de fabrication détaillés dans la description est que le substrat de l'assemblage comprend du silicium. Des étapes de procédé ultérieures sont par exemple compatibles avec les procédés de fabrication et les lignes de production établies pour les substrats comprenant du silicium. En conséquence, les étapes de procédé ultérieures sont par exemple réalisées à une échelle relativement grande, le substrat comprenant du silicium ayant par exemple des dimensions supérieures au substrat de type III-V, et sont par exemple relativement moins chères. Il y a par exemple plus de procédés de fabrication compatibles et disponibles pour un substrat comprenant du silicium que pour un substrat de type III-V.

Les procédés de fabrication détaillés dans la description sont par exemple utilisés pour la fabrication de diodes, par exemple de diodes Schottky, de transistors, par exemple de transistor à haute mobilité électronique ou de transistors bipolaires, par exemple de transistors bipolaires à hétérojonction, des systèmes micro-électromécaniques (MEMS , de l'anglais « Microelectromechanical systems »), d'émetteurs ou de récepteurs, d'amplificateurs de fréquences, de mélangeurs de fréquences, d'oscillateurs locaux, etc. Les procédés de fabrication détaillés dans la description sont par exemple utilisés pour la fabrication de composants électroniques configurés pour être utilisés à des fréquences radio, par exemple comprises dans la plage allant de 1 kHz à 300 GHz.

En particulier, lorsque le substrat de type III-V est un substrat composé de phosphore d'indium, les procédés de fabrication détaillés dans la description sont par exemple adaptés à la fabrication d'amplificateurs de puissance, par exemple fonctionnant à haute fréquence, par exemple jusqu'à 350 GHz, ayant des performances élevées grâce à l'utilisation du substrat composé de phosphore d'indium.

Un substrat composé de phosphore d'indium a par exemple une relativement grande mobilité électronique et est par exemple utilisé pour la formation de composants électroniques configurés pour des puissances relativement grandes et/ou des fréquences relativement élevées. Les procédés de fabrication détaillés dans la description et les assemblages électroniques en résultant ont par exemple les avantages d'un substrat de type III-V tout en étant compatibles avec des lignes de production et des procédés de fabrication compatibles avec les substrats comprenant du silicium.

Les procédés de fabrication détaillés dans la description sont par exemple en outre utilisés pour la fabrication de composants pour des applications en optique, par exemple pour l'obtention de flux à hauts-débits.

Des avantages des procédés de fabrication détaillés dans la description sont une possibilité de production à relativement grande échelle grâce au transfert sur un substrat comprenant du silicium et une réduction du coût de production associé. Un autre avantage est une relativement grande stabilité et une réduction de défauts cristallins et du stress grâce à des procédés utilisant une température et une pression relativement faibles.

L'utilisation d'une température et d'une pression relativement faibles a également l'avantage de préserver une qualité des couches de semiconducteur III-V obtenu par épitaxie en causant relativement peu de stress et de défauts cristallins dans les couches. En conséquence, les performances des composants électroniques obtenus sont préservées lors des procédés de fabrication détaillés dans la description.

Un avantage d'utiliser une résine configurée pour se transformer en un oxyde lors d'une étape d'assemblage est qu'une couche d'oxyde est par exemple façonnable. Par exemple, le dioxyde de silicium est compatible avec des procédés de gravure. Un autre avantage est la couche d'oxyde obtenue est robuste et stable lors d'une variation de température.

Un avantage d'utiliser le silsesquioxane d'hydrogène est que cette résine se transforme en un oxyde, le dioxyde de silicium, à une température relativement faible.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que des procédés de fabrication d'un transistor bipolaire soit illustré, ces procédés pourront être adaptés à la fabrication d'autres composants électroniques à partir des informations données dans la description et des connaissances générales de la personne du métier. Une couche de protection, telle que la couche 130 ou 315 est par exemple présente ou omise dans le premier et/ou dans le deuxième dispositif.

Enfin, la mise en œuvre pratique des modes de réalisation et variantes décrits est à la portée de la personne du métier à partir des indications fonctionnelles données ci-dessus.

## Revendications

1. Procédé d'assemblage d'un premier dispositif (100) comprenant un substrat de type III-V (105) avec un deuxième dispositif (150, 300) comprenant un substrat comprenant du silicium (155), le procédé comprenant :
1) former une couche de métal (120) sur une première portion d'une face (125) du premier dispositif (100) ;
2) former une première couche d'une résine (135) sur tout ou une partie de la face (125) du premier dispositif (100) après la formation de la couche de métal (120), la résine étant capable de se transformer en oxyde par l'application d'une étape de traitement ;
3) former une deuxième couche de la résine (160, 320) sur tout ou une partie d'une face (165, 310) du deuxième dispositif (150, 300) ; et
4) lier la face (125) du premier dispositif (100) obtenu à l'étape 2) à la face (165, 310) du deuxième dispositif (150, 300) obtenu à l'étape 3), en appliquant l'étape de traitement pour transformer la première couche de la résine (135) et la deuxième couche de la résine (160, 320) en une couche d'oxyde (170, 370).

2. Procédé selon la revendication 1, comprenant en outre, entre l'étape 1) et l'étape 2) :
- former une couche de protection (130) sur une deuxième portion de la face (125) du premier dispositif obtenu à l'étape 1).

3. Procédé selon la revendication 2, dans lequel la couche de protection (130) recouvre la couche de métal (120) et recouvre une partie d'une surface du substrat (105) du premier dispositif (100), et dans lequel, à la suite de l'étape 4), le deuxième dispositif (150, 300) n'est séparé de la couche de métal (120) qu'uniquement par la couche d'oxyde (170, 370) et la couche de protection (130).

4. Procédé selon l'une quelconque des revendications 1 à 3, comprenant en outre, après l'étape 2) et avant l'étape 4) :
- une étape de planarisation du premier dispositif (100) pour rendre la couche de métal (120) apparente.

5. Procédé selon la revendication 4, comprenant en outre, avant l'étape 3) :
- former une autre couche de métal (305) sur une première portion de la face (310) du deuxième dispositif (300),
et dans lequel, à l'étape 4), la couche de métal (120) et l'autre couche de métal (305) sont liées entre elles.

6. Procédé selon la revendication 5, comprenant en outre, après la formation de l'autre couche de métal (305) et avant l'étape 3) :
- former une autre couche de nitrure de silicium (315) sur une deuxième portion de la face (310) du deuxième dispositif (300).

7. Procédé selon l'une quelconque des revendications 1 à 6, dans lequel l'étape de traitement est une étape de thermocompression.

8. Procédé selon la revendication 7, dans lequel l'étape de thermocompression est effectuée à une température inférieure ou égale à 250°C et de préférence inférieure ou égale à 200°C, et à une pression inférieure ou égale à 1200 mbar.

9. Procédé selon l'une quelconque des revendications 1 à 8, dans lequel la résine comprend du silsesquioxane d'hydrogène.

10. Procédé selon l'une quelconque des revendications 1 à 9, dans lequel, avant l'étape 1), le substrat de type III-V (105) du premier dispositif (100) est composé d'un semiconducteur III-V et comprend un empilement d'une ou plusieurs couches (110) dopées comprenant le semiconducteur III-V.

11. Assemblage (175, 375) comprenant :
- un premier dispositif (100) comprenant :
1) une couche de métal (120) ; et
2) un substrat de type III-V (105) recouvrant une première face de la couche de métal (120) ; et
- un deuxième dispositif (150, 300) comprenant un substrat comprenant du silicium (155) ;
une face (125) du premier dispositif (100), opposée à la première face de la couche de métal, et une face (165, 310) du deuxième dispositif (150, 300) étant liées entre elles par une couche d'oxyde (170, 370).

12. Assemblage selon la revendication 11, dans lequel le deuxième dispositif (300) comprend en outre une autre couche de métal (305) recouvrant une portion du substrat comprenant du silicium (155) et dans lequel la couche de métal (120) et l'autre couche de métal (305) sont liées entre elles au niveau de la face (125) du premier dispositif (100) et de la face (310) du deuxième dispositif (300).

13. Assemblage selon la revendication 11 ou 12, dans lequel le substrat de type III-V (105) du premier dispositif (100) est composé d'un semiconducteur III-V et comprend un empilement d'une ou plusieurs couches (110) dopées comprenant le semiconducteur III-V, l'empilement de l'une ou plusieurs couches (110) dopées formant un transistor bipolaire.

14. Assemblage selon l'une quelconque des revendications 11 à 13, dans lequel l'oxyde est du dioxyde de silicium.

15. Assemblage selon l'une quelconque des revendications 11 à 14, dans lequel le premier dispositif (100) comprend en outre une couche de protection (130) à l'interface entre la couche d'oxyde (170, 370) et la couche de métal (120).
